# EUROPEAN PATENT APPLICATION

(11) **EP 2 682 767 A2**
(43) Date of publication of application: **08.01.2014**
(21) Application number: 13173687.8
(22) Date of filing: 26.06.2013
(51) Int. Cl.: G01R 25/00, G01R 25/04, H01P 1/18

(54) **Phase shifter with a reduced influence of errors**

(30) Priority: 05.07.2012 SI 201200224
(71) Applicant: Cobik, 5250 Solkan (SI)
(72) Inventor: Vidmar, Matja, 5000 NOVA GORICA (SI); Zagorec, Robert, 8000 NOVO MESTO (SI); Tratnik, Jurij, 1290 GROSUPLJE (SI); Batagelj, Bo tjan, 1000 LJUBLJANA (SI)
(74) Representative: Ivancic, Bojan

(57) **Abstract**

The present invention refers to a phase shifter with a reduced influence of errors which measures the phase difference between two signals. According to the invention, the system consists of at least two phase detectors (3, 4) with the wanted signal (1) and the actual signal (2) on their inputs, the respective detectors (3, 4) in a series connected to the respective adaptation circuits of the voltage levels (6, 7) with a pair of signals (8, 9; 10, 11) at their inputs coming from the respective phase detector (3, 4), and an adjustable resistance splitter (16) with a pair of signals (12, 13; 14, 15) coming from the respective adjustment circuits (6, 7) at its input and the wanted or desired signal (17) at its output.

## Description

The present invention relates to a phase shifter with a reduced influence of errors, which measures the phase difference between two signals.

There have been systems of the aforementioned type where, for the phase shift of the signal, either analogue or digital radio-frequency phase shifters are used. A phase shifter is needed in order to bring any system for detecting phase differences to the optimal operating point. To detect the phase difference of two signals either passive diode mixers, active phase detectors on the basis of Gilbert cells, analogue multipliers, a XOR logic gate, and similar are used. Low-frequency processing of the output signal of the phase detector can be constructed with two analogue multipliers built of or replaced with a splitter of square connected resistors with a selector switch. Existing solutions for the phase comparison (detection) of the signal have drawbacks, such as the amplitude-phase dependence, narrow bandwidth, low frequency range of operation, noise, and a DC voltage offset. All known systems for the phase shift have one disadvantage in common, that is, temperature dependency.

The object of the present invention is to create a phase shifter by means of which the system for detecting the phase difference is brought to the optimal operating point and at the same time to remedy the deficiencies of known solutions used for the phase shift of the signal.

The object as set above is solved according to the invention by the features given in the characterising part of the claim 1. Details of the invention are disclosed in the sub-claims.

The invention is described in more detail on the basis of the embodiment and with the help of the attached drawings, where
Fig. 1 shows a phase-detection system according to the invention in a schematic view,
Fig. 2 shows a voltage selector system according to the invention in a schematic view.

A phase shifter, which measures the phase difference between two input signals 1, 2, in the presented embodiment between the wanted radio-frequency signal 1 and the actual radio-frequency signal 2, according to the invention consists of at least two phase detectors 3, 4. Said wanted signal 1 is divided into two equal branches 1a, 1b, where the first branch 1a leads directly to a first input 3b of a first phase detector 3 and the second branch 1b leads directly to a first input 4a of a second phase detector 4. The actual signal 2 is also divided into two equal branches 2a, 2b, wherein the first branch 2a leads directly to a second input 3a of the first phase detector 3, while the second branch 2b leads to a delay line 5. In said delay line 5, the second branch 2b of the signal 2 is delayed by π/2 relative to the first branch 2a of the signal 2, and as a delayed signal 2c leads to a second input 4b of the second phase detector 4.

To each of phase detectors 3 and 4 one adaptation circuit 6, 7 of the voltage levels in the series is connected, wherein from the respective phase detector 3, 4 to a respective adaptation circuit 6, 7 a pair of signals 8, 9; 10, 11 is guided. The first pair of signals 8, 9 entering adaptation circuit 6 represents one output voltage signal 8, which carries information about the phase difference between signals 1a, 2a entering the first phase detector 3, and a reference signal 9, which represents a voltage reference of said phase detector 3. The second pair of signals 10, 11 entering the second adaptation circuit 7 represents one output voltage signal 10, which carries information about the phase difference between the two signals 1b, 2c that enters into the second phase detector 4; and one reference signal 11, which represents the voltage reference of said phase detector 4. From each said adaptation circuit 6 or 7 exits a pair of signals 12, 13; 14, 15, wherein the respective second exiting signal 13; 15 has the opposite or inverse sign of the respective first exiting signal 12; 14. These pairs of output signals 12, 13; 14, 15 from adaptation circuits 6, 7 is further directed to the adjustable resistive splitter 16, from which the wanted or desired signal 17 exits.

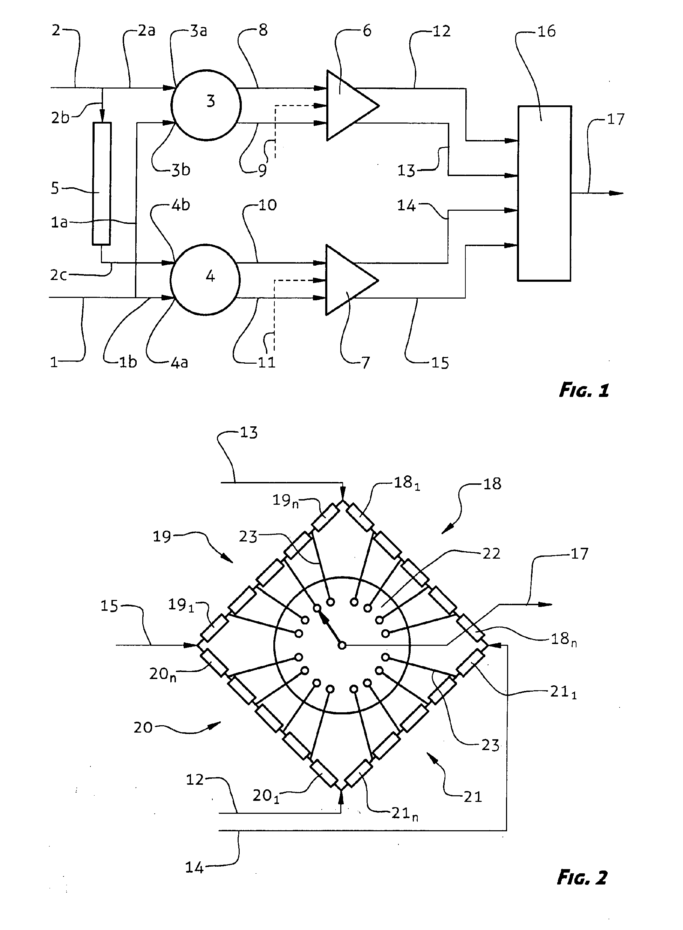

It is provide for in the present embodiment that the respective reference signal 9, 11 to a respective adaptation circuit 6, 7 is taken from the respective phase detector 3, 4. However, it is also possible to design such a circuit in which said reference signal 9, 11 to a respective adaptation circuit 6, 7 is taken from the external source known per se (in Fig. 1 shown with a dashed line).

Said resistive splitter 16 is comprised of square-shaped connected sets 18, 19, 20, 21 of resistors 18₁ ... 18ₙ, 19₁ ... 19ₙ, 20₁ ... 20ₙ, 21₁ ... 21ₙ wherein each set of resistors represents one of the sides of the square. The number of resistors in each set is preferably the same, wherein the previously mentioned sets 18, 19, 20, 21 are mutually symmetrical or the same. Signals 12, 13, 14, 15 exiting the aforementioned adaptation circuits 6, 7 are connected to the aforementioned resistive splitter 16 so that the respective signals 12, 13 or 14, 15 of the same adaptation circuits 6 or 7 run in the opposite corners of resistive splitter 16.

Additionally, said resistive splitter 16 comprises adjustable switch 22, which via line 23 is connected with said set of resistors 18; 19; 20; 21, whereby the respective line 23 is connected to a respective set of resistors 18, 19, 20, 21 at a point of respective adjacent resistors 18₁ ... 18ₙ, 19₁ ... 19ₙ, 20₁ ... 20ₙ, 21₁ ... 21ₙ. In this way, a virtual coordinate system is created, where at any point the influence of said phase detectors 3, 4 is appropriately weighted. According to the invention, the symmetry of the circuit in the system contributes to the low impact of error elements because they will be mutually subtracted. With said switch 22 the wanted connection between the sets of resistors 18; 19; 20; 21 and input signals 12, 13, 14, 15 in said splitter 16 could be selected, thus creating a deviation of the measured phase.

## Claims

1. A phase shifter with a reduced influence of errors, which measures the phase difference between two signals, ***characterised in that*** it comprises at least two phase detectors (3, 4) with a wanted signal (1) and an actual signal (2) on their inputs, the respective phase detector (3, 4) is in a series followed by the respective adaptation circuit of the voltage levels (6, 7) with a pair of signals (8, 9; 10, 11) on their inputs, and an adjustable resistance splitter (16) with a pair of signals (12, 13; 14, 15) coming out of the respective adjustment circuit (6, 7) on its inputs and from which exit the wanted or desired signal (17).

2. The phase shifter according to claim 1, ***characterised in that*** respective resistance splitter (16) comprises a square-shaped connected sets (18; 19; 20; 21) of resistors (18₁ ... 18ₙ, 19₁ ... 19ₙ; 20₁ ... 20ₙ, 21₁ ... 21ₙ) in a series, wherein the signals (12, 13; 14, 15) exiting said adaptation circuits (6, 7) are connected to said resistive splitter (16) in a manner that the respective signals (12, 13) or (14, 15) of the adaptation circuit (6) or (7) run in the opposite corners of said resistive splitter (16), and an adjustable switch (22) which is via the line (23) connected to said set of resistors (18; 19; 20; 21), wherein a respective line (23) is connected to a respective set of resistors (18; 19; 20; 21) at the point of the respective adjacent resistors (18₁ ... 18ₙ, 19₁ ... 19ₙ; 20₁ ... 20ₙ, 21₁ ... 21ₙ).

3. The phase shifter according to claims 1 and 2, ***characterised in that*** each said set of resistors (18; 19; 20; 21) represents one of the sides of the square, wherein the number of said resistors in each set is preferably the same, and wherein said set of resistors (18; 19; 20; 21) is mutually symmetrical or the same.

4. The phase shifter according to claim 1, ***characterised in that*** said wanted signal (1) is split into two equal branches (1a, 1b), wherein said branch (1a) leads directly to the first input (3b) of the first phase detector (3) and said second branch (1b) leads directly to the first input (4a) of the second phase detector (4), and that said actual signal (2) is divided into two equal branches (2a, 2b), wherein said first branch (2a) leads to a second port (3a) of the first phase detector (3), while said second branch (2b) is via a delay line (5) as a delay signal (2c) fed to the second input (4b) of the second phase detector (4).

5. The phase shifter according to claims 1 and 4, ***characterised in that*** in said delay line (5) said second branch (2b) of the signal (2) is delayed by the π/2 relative to said first branch (2a) of the signal (2), and is as a delayed signal (2c) fed to the second input (4b) of the second phase detector (4).

6. The phase shifter according to claim 1, ***characterised in that*** a pair of incoming signals (8, 9) in said first adaptation circuit (6) represents one voltage output signal (8), which is coming out of said first phase detector (3) and carries the information about the phase difference between said signals (1a, 2a), and one reference signal (9), and that said second adaptation circuit (7) of the second pair of incoming signals (10, 11) represents the one output voltage signal (1) coming from said second phase detector (4) and carries the information about the phase difference between the two signals (1b, 2c), and one reference signal (11).

7. The phase shifter according to claim 1, ***characterised in that*** the respective outgoing signal (13; 15) from the respective adaptation circuit (6, 7) has the opposite or inverse sign relative to the respective parallel outgoing signal (12; 14) from the respective adjustment circuit (6, 7).

8. The phase shifter according to any one of the preceding claims, ***characterised in that*** said signal (1, 2) is the radio-frequency signal.
